# FASCICULE DE BREVET EUROPEEN

(11) **EP 1 319 777 B1**
(45) Date de publication et mention de la délivrance du brevet: **29.03.2006**
(21) Numéro de dépôt: 02027784.4
(22) Date de dépôt: 11.12.2002
(51) Int. Cl.: E05B 17/22, E05B 65/20, H03K 17/955

(54) **Poignée d'ouvrant équipée d'un capteur de présence du type capacitif**
Türgriff ausgerüstet mit einem kapazitiven Anwesenheitsdetektor
Door handle equipped with a capacitive presence detector

(30) Priorité: 12.12.2001 FR 0116421
(43) Date de publication de la demande: 18.06.2003
(73) Titulaire: VALEO SECURITE HABITACLE S.A.S., 94042 Créteil Cédex (FR)
(72) Inventeur: Gehin, Frédéric, 94000 Créteil (FR); Derouet, Hugues, 75020 Paris (FR)
(74) Mandataire: Rosolen-Delarue, Katell

(56) Documents cités:
- EP-A- 0 856 425
- EP-A- 0 955 431
- EP-A- 0 999 324
- EP-A- 1 154 110
- WO-A-01/40606
- DE-A- 10 007 500
- US-A- 4 410 843
- US-A- 6 075 294

## Description

La présente invention concerne une poignée d'ouvrant, notamment pour véhicule automobile, comprenant un capteur de présence du type capacitif destiné à la détection de présence d'un utilisateur au niveau de la poignée d'ouvrant.

Dans le domaine des véhicules automobiles, la poignée d'ouvrant, qui servait à l'actionnement mécanique d'une serrure pour l'ouverture de l'ouvrant a beaucoup évolué et se présente maintenant comme une interface privilégiée entre un utilisateur portant un identifiant et un système de gestion embarqué sur le véhicule, permettant ainsi la réalisation de systèmes d'accès dits "mains libres".

Un but de ces systèmes d'accès mains libres est de réaliser le verrouillage et/ou le déverrouillage d'un véhicule automobile sans clé mécanique ni télécommande.

Pour ce faire, une authentification de l'utilisateur, souhaitant, par exemple, accéder à son véhicule, est effectuée par dialogue entre le système de gestion embarqué sur le véhicule et l'identifiant (réalisé par exemple sous la forme d'un badge) porté par l'utilisateur.

Pour éviter une interrogation incessante, par le système de gestion embarqué, d'un éventuel identifiant présent dans l'entourage du véhicule, on prévoit généralement de ne déclencher l'interrogation que lorsque la présence d'un utilisateur a été détectée à proximité du véhicule.

Des moyens déclenchant utilisés dans les systèmes d'accès mains libres sont, par exemple, des capteurs utilisant des technologies optiques ou capacitives, ou des interrupteurs. Ces différents moyens déclenchant sont disposés à proximité ou au niveau d'une poignée du véhicule et permettent la détection de présence d'un utilisateur approchant sa main de la poignée pour accéder à son véhicule. Cette détection de présence de l'utilisateur permet ensuite d'initier l'authentification de l'utilisateur en vue d'autoriser son accès au véhicule.

De manière générale, lorsque ces moyens déclenchant sont réalisés sous la forme des capteurs de présence de type capacitifs, ils comprennent au moins une électrode de mesure et une électrode de référence couplées électromagnétiquement pour définir une zone de détection de présence d'un utilisateur. La présence d'un utilisateur au niveau de la zone de détection entraîne une variation de ce couplage électromagnétique permettant la détection de présence de l'utilisateur.

Habituellement, ces capteurs de présence se présentent sous la forme d'un boîtier parallélépipédique allongé et rigide intégrant les différents éléments formant le capteur. Ainsi, les électrodes, généralement réalisées sous la forme d'empreintes métalliques sur une plaque de circuit imprimé, sont disposées dans le boîtier et s'étendent le long de celui-ci.

Ce boîtier est destiné à être disposé au niveau de la poignée et relié au système de gestion embarqué sur le véhicule pour échanger des informations avec ce dernier.

Le positionnement du boîtier, intégrant les électrodes du capteur, est souvent délicat car il doit être réalisé correctement de façon à assurer un fonctionnement optimal du capteur, à savoir une détection fiable de la présence de l'utilisateur au niveau de la poignée.

Ainsi, compte tenu de ce qui précède et du fait qu'il existe une grande diversité de poignées présentant des formes et géométries très variables, il est souvent nécessaire de développer autant de boîtiers qu'il y a de modèles de poignées, ce qui est coûteux.

Le document EP-A-0955431 propose d'utiliser un capteur dans lequel les électrodes de ce dernier sont réalisées sous la forme de fils métalliques. Les électrodes d'un tel capteur sont ensuite intégrées dans une poignée.

Pour les raisons évoquées précédemment, le but de la présente invention est de réaliser un produit standard pouvant s'adapter à tous les types de poignées, aussi bien à des poignées présentant une structure dite frigo qu'à des poignées présentant une structure dite palette.

Ce but est atteint selon la présente invention qui consiste à proposer une poignée d'ouvrant selon la revendication 1.

La présente invention présente également des caractéristiques secondaires particulièrement avantageuses qui seront présentées dans la description qui suit.

L'invention sera mieux comprise au cours de la description explicative détaillée d'exemples non limitatifs faisant référence aux figures annexées qui représentent :
- Figure 1, une vue en perspective d'un capteur pour la poignée d'ouvrant,
- Figure 2, une vue en perspective de la face arrière d'une poignée d'ouvrant sur laquelle est positionné le capteur de la figure 1,
- Figure 3, une vue simplifiée en coupe selon l'axe X-X' de la poignée d'ouvrant de la figure 2.

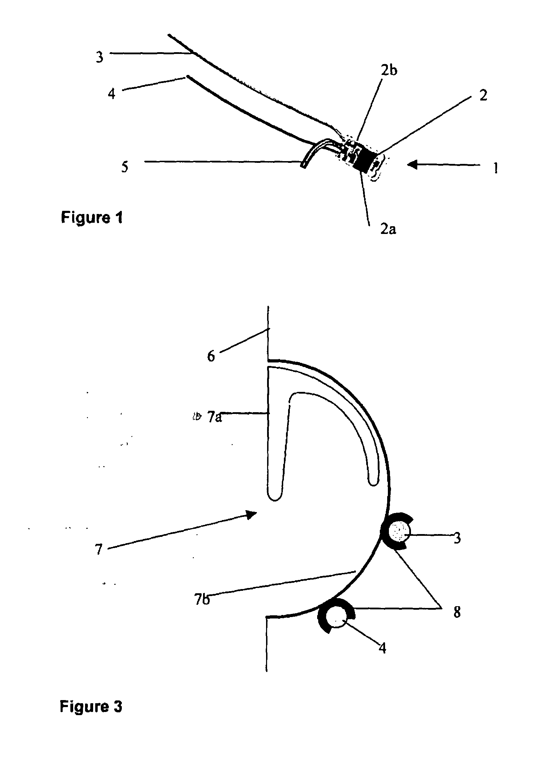

La figure 1 présente une vue en perspective d'un capteur de présence pour la poignée d'ouvrant. Ce capteur de présence, désigné par la référence 1, se compose d'un module de contrôle 2, formé de composants électroniques 2a (non identifiés individuellement) positionnés sur un circuit imprimé 2b, d'une électrode de mesure 3, d'une électrode de référence 4, ainsi que de câbles 5 électriquement conducteurs permettant l'alimentation électrique du capteur et sa communication avec d'autres équipements.

Ce capteur 1 est destiné à la détection de présence d'un utilisateur au niveau d'une poignée d'ouvrant, notamment pour véhicule automobile.

Dans son application automobile, le module de contrôle 2 réalise la gestion électronique de la détection de présence de l'utilisateur et communique avec un système de gestion embarqué sur le véhicule pour la commande de fonctions données telles que, par exemple, le verrouillage et/ou le déverrouillage du véhicule.

Notamment, dans le cadre d'un véhicule équipé d'un système d'accès mains libres, lors de la détection de présence d'un utilisateur approchant sa main de la poignée du véhicule, le module de contrôle 2 transmet une information de détection au système de gestion embarqué sur le véhicule pour que celui-ci initie une communication avec l'identifiant porté par l'utilisateur en vue de l'identifier et d'autoriser son accès au véhicule, si la fonction commandée est le déverrouillage du véhicule.

Dans le cas présent, les électrodes 3, 4 ont toutes deux une extrémité reliée au module de contrôle 2, l'autre extrémité étant libre. Elles présentent une structure allongée.

En fonctionnement, il s'établit, entre les deux électrodes 3 et 4, un couplage électromagnétique définissant une zone de détection de présence de l'utilisateur (non représentée), au niveau de la poignée.

Les deux électrodes sont généralement disposées, au niveau de la poignée, de manière assez espacée de façon à ce que le couplage qui s'établit soit suffisamment important pour que le capteur soit d'une sensibilité compatible avec la détection de présence d'un utilisateur.

Selon l'invention, les électrodes 3, 4 sont réalisées sous la forme d'un fil métallique souple. Cette , structure particulière permet de les positionner directement au niveau de la poignée, sans utilisation de boîtier rigide.

Ainsi quelque soient la forme et le profil de la poignée, les électrodes "pourront être positionnées au mieux pour suivre son profil et assurer une définition de la zone de détection et un fonctionnement optimaux du capteur de présence.

De manière avantageuse, les électrodes 3, 4, formés de fils métalliques souples, sont entourés d'une gaine plastique isolante électriquement. De la sorte, les électrodes peuvent être directement positionnées sur la poignée même si celle-ci présente une structure métallique conductrice.

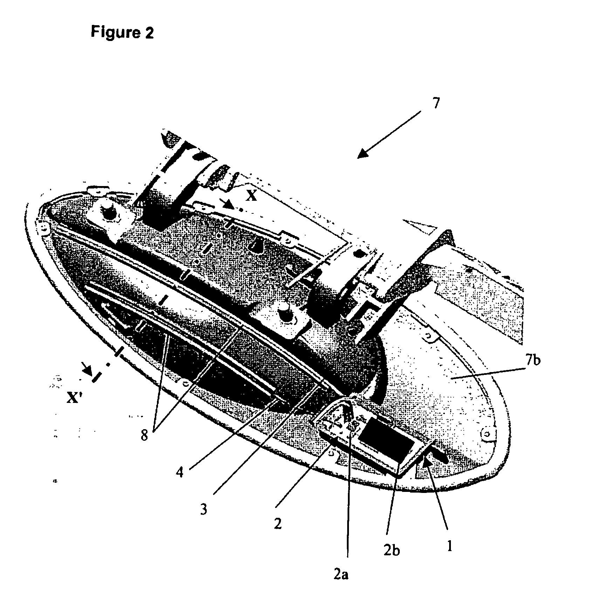

La figure 2, représentant une vue en perspective de la face arrière d'une poignée d'ouvrant intégrant le capteur décrit à la figure 1, et la figure 3, représentant de manière simplifiée, une vue en coupe transversale selon l'axe X-X' de la poignée d'ouvrant de la figure 2, seront décrites conjointement pour faciliter la compréhension du lecteur.

Sur ces figures, on a représenté une poignée d'ouvrant 7 intégrée au niveau d'un ouvrant 6, notamment de véhicule automobile, et comprenant une partie de préhension 7a mobile par rapport à l'ouvrant 6 , destinée à être actionnée par l'utilisateur, et une partie fixe 7b positionnée sur l'ouvrant 6.

Selon un mode de réalisation possible de l'invention, un capteur de présence tel que celui décrit à la figure 1 est positionné au niveau de la partie fixe 7b de la poignée.

Dans le mode de réalisation présenté, l'électrode de mesure 3 est disposée dans la partie médiane et selon l'axe longitudinal de la partie fixe 7b alors que l'électrode de référence 4 s'étend longitudinalement à proximité du bord inférieur de la partie fixe 7b.

Les deux électrodes 3 et 4 sont disposées de manière espacée au niveau de la partie fixe 7b de la poignée et selon l'axe longitudinal de celle-ci de sorte qu'il puisse s'établir un couplage électromagnétique entre les deux électrodes et que la zone de détection de présence ainsi créée soit suffisamment étendue.

Selon l'invention, les électrodes de mesure 3 et de référence 4 sont réalisées sous la forme de fils conducteurs souples, par exemple de section circulaire, fixés sur la partie fixe 7b et obligatoirement isolés électriquement par rapport à cette partie, lorsque cette dernière est conductrice.

Ainsi que présenté sur la coupe de la figure 3, la poignée 7 présente un profil concave et la zone de détection s'étend généralement dans l'espace formé entre les parties 7a et 7b pour que la présence d'un utilisateur puisse être détecté dès que celui-ci s'apprête à saisir la partie mobile 7a de la poignée. Compte tenu de ce profil concave, on comprend que la réalisation des électrodes 3 et 4 sous la forme de fils métalliques souples, conformément à l'invention, est particulièrement avantageuse car elle permet un positionnement direct des électrodes du capteur de présence 1 quelque soit le profil de la poignée 7.

La fixation des électrodes 3 et 4 sur la poignée 7 est réalisée selon l'invention à l'aide de moyens de maintien et de guidage 8 présents au niveau de la partie fixe 7b poignée 7. Ces moyens de maintien et de guidage 8 permettent, en plus de réaliser la fixation des électrodes sur la poignée 7, de réaliser un guidage dans le positionnement des électrodes de manière qu'elles soient correctement disposées. Cette disposition exacte des électrodes permet d'assurer un fonctionnement optimal du capteur et d'obtenir une détection fiable de la présence de l'utilisateur au niveau de la poignée 7 dans une zone de détection correctement délimitée.

Comme visible sur la figure 2, ces moyens de maintien et de guidage 8 peuvent prendre la forme de rainures formées sur la partie fixe 7b de la poignée. Ces rainures 8 sont, par exemple, issues de moulage lors de la fabrication de la poignée. Elles présentent une section (figure 3) propre à retenir le fil métallique souple formant l'électrode 3, 4 une fois que ce dernier est mis en place. Dans l'exemple présenté, les rainures 8 sont de section circulaire.

Selon une autre alternative non représentée, la poignée 7 présente, au niveau de sa partie fixe 7b accueillant les électrodes 3 et 4, des plots formant moyens de maintien et de guidage 8. Ces plots sont, par exemple, issus de moulage lors de la fabrication de la poignée, et disposés de manière alternée sur deux lignes en parallèle pour permettre un meilleur maintien de l'électrode et guider son positionnement lors de sa mise en place sur la poignée.

Lorsque la poignée 7, ainsi que les moyens de maintien et de guidage 8 qui en sont issus, sont métalliques, les fils métalliques souples formant les électrodes 3 et 4 sont isolés de cette masse métallique par une gaine plastique isolante entourant les électrodes.

On aurait pu également disposer le capteur de présence conforme à l'invention en un autre endroit de la poignée, par exemple au niveau de la partie mobile 7a.

Par ailleurs, dans la description précédente, le module de contrôle 2 du capteur de présence est positionné au niveau de la poignée mais il est tout à fait envisageable qu'il soit disposé au niveau du véhicule, à un endroit éloigné de la poignée. Le couplage électromagnétique qui s'établit entre les électrodes, depuis le module de contrôle jusqu'à la poignée, est modifié le long du trajet par des moyens connus de sorte qu'aucune détection ne peut être opérée entre le module de contrôle 2 et la poignée 7. Au niveau de la poignée 7, le couplage électromagnétique entre les électrodes est rétabli et le capteur de présence fonctionne comme décrit précédemment.

Dans l'ensemble de cette demande le terme capteur de présence a été utilisé. Il faut cependant noter qu'il existe plusieurs types capteurs de présence se déclinant en :
- capteur d'approche permettant de détecter l'approche d'un utilisateur au niveau de la poignée ; et
- capteur tactile permettant de détecter une action volontaire de toucher de l'utilisateur au niveau de la poignée.

De manière générale, le capteur d'approche est utilisé pour détecter l'approche de l'utilisateur en vue d'initier une communication entre l'identifiant et le système embarqué dans le véhicule alors que le capteur tactile est utilisé en vue de détecter une action volontaire de l'utilisateur lorsqu'il souhaite verrouiller le véhicule.

Ces deux types de capteurs de présence fonctionnent sur le même principe technique, le seul élément différenciant étant leur sensibilité, de sorte que l'invention revendiquée est mise en oeuvre aussi bien sur des capteurs d'approche que sur des capteurs tactiles.

Dans les exemples décrits, les électrodes 3 et 4 sont chacune formée d'un fil métallique souple unique mais, de manière équivalente, chaque électrode pourra être réalisée sous la forme d'un faisceau de fils métalliques souples.

L'invention permet donc une complète adaptation d'un même capteur de présence au niveau d'une grande diversité de poignées d'ouvrant en termes de forme, de géométrie ou de profil de la poignée ou encore de contraintes d'intégration du capteur imposées par cette poignée.

Grâce à l'invention, on a réalisé une poignée d'ouvrant intégrant un capteur de présence présentant une détection optimale d'un utilisateur s'approchant de la poignée.

## Revendications

1. Poignée d'ouvrant, notamment pour véhicule automobile, comprenant un capteur (1) du type capacitif comportant au moins une électrode de mesure (3) et une électrode de référence (4) destinées à être couplées électromagnétiquement et positionnées au moins en partie au niveau de ladite poignée et dans lequel au moins une électrode (3, 4) du capteur (1) est réalisée sous la forme d'au moins un fil métallique souple de manière à permettre son positionnement direct au niveau de la poignée (7) quelque soit le profil de cette dernière, la poignée (7) d'ouvrant comprenant des moyens de maintien et de guidage (8) du fil métallique souple, formant l'électrode (3, 4), disposés au niveau de la poignée (7).

2. Poignée d'ouvrant selon la revendication 1, **caractérisée en ce que** les moyens de maintien et de guidage (8) présentent une section circulaire propre à retenir le fil métallique souple.

3. Poignée d'ouvrant selon la revendication 1 ou 2, **caractérisée en ce que** les moyens de maintien et de guidage (8) sont issus de moulage lors de la réalisation de la poignée (7).

4. Poignée d'ouvrant selon l'une quelconque des revendications précédentes comprenant une partie de préhension (7a) mobile par rapport à l'ouvrant, destinée à être actionnée par l'utilisateur, et une partie fixe (7b) positionnée sur l'ouvrant, **caractérisée en ce qu'**au moins une électrode (3, 4) du capteur (1) est agencée sur la partie fixe (7b) de la poignée (7).

5. Poignée d'ouvrant selon la revendication 4, **caractérisée en ce que** le capteur (1) comprend en outre un module de contrôle (2) positionné au niveau de la partie fixe (7b) de ladite poignée.

## Claims

1. A door handle, especially for a motor vehicle, which includes a sensor (1) of the capacitive type comprising at least one measuring electrode (3) and a reference electrode (4), which electrodes are arranged to be electromagnetically coupled together and positioned at least partly in proximity to the said handle, and wherein at least one electrode (3, 4) of the sensor (1) is made in the form of at least one flexible metallic wire, whereby to enable it to be positioned directly at the level of the handle (7) whatever the profile of the latter may be, the door handle (7) including means (8) for retaining and guiding the flexible metallic wire, constituting the electrode (3, 4), that is disposed in proximity to the handle (7).

2. A door handle according to Claim 1, **characterised in that** the retaining and guiding means (8) have a circular cross section adapted to retain the flexible metallic wire.

3. A door handle according to Claim 1 or Claim 2, **characterised in that** the retaining and guiding means (8) are formed by moulding during manufacture of the handle (7).

4. A door handle according to any one of the preceding Claims, including a gripping portion (7a) which is movable with respect to the door and which is adapted for actuation by the user, and a fixed portion (7b) which is positioned on the door, **characterised in that** at least one electrode (3, 4) of the sensor (1) is arranged on the fixed portion (7b) of the handle (7).

5. A door handle according to Claim 4, **characterised in that** the sensor (1) further includes a control module (2) positioned in proximity to the fixed portion (7b) of the said handle.

## Patentansprüche

1. Türgriff, insbesondere für Kraftfahrzeuge, mit einem Sensor (1) vom kapazitiven Typ, der zumindest eine Messelektrode (3) und eine Referenzelektrode (4) enthält, die dazu bestimmt sind, elektromagnetisch gekoppelt zu werden und zumindest teilweise im Bereich des Türgriff positioniert sind, und bei dem zumindest eine Elektrode (3, 4) des Sensors (1) in Form zumindest eines biegsamen Drahts ausgeführt ist, so dass deren Positionierung direkt im Bereich des Türgriffs (7) unabhängig vom Profil des letztgenannten möglich ist, wobei der Türgriff (7) Mittel (8) zum Halten und Führen des die Elektrode (3, 4) bildenden biegsamen Drahts enthält, die im Bereich des Türgriffs (7) angeordnet sind.

2. Türgriff nach Anspruch 1, **dadurch gekennzeichnet, dass** die Halte- und Führungsmittel (8) einen kreisrunden Querschnitt aufweisen, der den biegsamen Draht festhalten kann.

3. Türgriff nach Anspruch 1 oder 2, **dadurch gekennzeichnet, dass** die Halte- und Führungsmittel (8) bei der Herstellung des Türgriffs (7) geformt werden.

4. Türgriff nach einem der vorangehenden Ansprüche, mit einem Greifteil (7a), der bezüglich der Tür beweglich und dazu bestimmt ist, von dem Benutzer betätigt zu werden, und mit einem festen Teil (7b), der an der Tür positioniert ist, **dadurch gekennzeichnet, dass** zumindest eine Elektrode (3, 4) des Sensors (1) an dem festen Teil (7b) des Türgriffs (7) angeordnet ist.

5. Türgriff nach Anspruch 4, **dadurch gekennzeichnet, dass** der Sensor (1) ferner ein Kontrollmodul (2) enthält, das im Bereich des festen Teils (7b) des Türgriffs positioniert ist.
